# EUROPEAN PATENT SPECIFICATION

(11) **EP 2 341 548 B1**
(45) Date of publication and mention of the grant of the patent: **24.04.2019**
(21) Application number: 10008525.7
(22) Date of filing: 16.08.2010
(51) Int. Cl.: H01L 31/0216

(54) **Solar cell module**
Solarzellenmodul
Module de cellule solaire

(30) Priority: 29.12.2009 KR 20090132326
(43) Date of publication of application: 06.07.2011
(73) Proprietor: LG Electronics Inc., Yeongdeungpo-gu Seoul 150-721 (KR)
(72) Inventor: Kim, Jongdae, Seoul 137-724 (KR); Hong, Jongkyoung, Seoul 137-724 (KR); Lee, Giwon, Seoul 137-724 (KR)
(74) Representative: Katérle, Axel

(56) References cited:
- US-A1- 2003 070 706
- US-A1- 2008 289 681
- US-A1- 2009 007 966

## Description

### BACKGROUND OF THE INVENTION

### Field of the Invention

Embodiments of the invention relate to a solar cell module.

### Description of the Related Art

Recently, as existing energy sources such as petroleum and coal are expected to be depleted, interests in alternative energy sources for replacing the existing energy sources are increasing. Among the alternative energy sources, solar cells generating electric energy from solar energy have been particularly spotlighted.

A solar cell generally includes a substrate, an emitter layer, and electrodes respectively connected to the substrate and the emitter layer. The substrate and the emitter layer are respectively formed of semiconductors of different conductive types, for example, p-type and n-type semiconductors or n-type and p-type semiconductors. A p-n junction is formed at an interface between the substrate and the emitter layer.

When light is incident on the solar cell, electrons inside the semiconductors become free electrons (hereinafter referred to as "electrons") by the photoelectric effect. Further, electrons and holes respectively move to the n-type semiconductor (e.g., the emitter layer) and the p-type semiconductor (e.g., the substrate) in accordance with the principle of the p-n junction. The electrons moving to the emitter layer and the holes moving to the substrate are respectively collected by the respective electrodes electrically connected to the emitter layer and the substrate.

At least one current collector, such as a bus bar, is formed on each of the emitter layer and the substrate. The at least one current collector on the emitter layer is electrically connected to the electrode of the emitter layer, and the at least one current collector on the substrate is electrically connected to the electrode of the substrate.

Because a very small amount of voltage and current are generated from one solar cell having the above-described structure, a solar cell module fabricated by connecting the several solar cells having the above-described structure in series or parallel to one another is used to obtain a desired output. The solar cell module is a moisture-proof module fabricated in a panel form.

US 2003/0070706 A1 discloses a thin film solar battery module in which a flat glass substrate with non-monocrystal silicon type thin film solar cells formed thereon, a space layer, and a chilled figured glass are sequentially stacked in this order.

### SUMMARY OF THE INVENTION

Embodiments of the invention provide a solar cell module capable of improving production efficiency of the solar cell module.

Embodiments of the invention also provide a solar cell module capable of reducing manufacturing cost of the solar cell module.

In one aspect, there is a solar cell module including a plurality of solar cells, a protective layer positioned on the plurality of solar cells, and a transparent member positioned on the protective layer, the transparent member including a first anti-reflection portion an inner surface of the transparent member, the inner surface being a surface facing the plurality of solar cells, as further defined in the claims.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is an exploded perspective view schematically showing a solar cell module according to an embodiment of the invention;
FIG. 2 is a partial perspective view of an exemplary solar cell according to an embodiment of the invention; and
FIGS. 3A to 10 illustrate various configurations of an anti-reflection portion positioned in an inner surface of a transparent member according to an embodiment of the invention.

### DETAILED DESCRIPTION OF THE EMBODIMENTS

The invention will be described more fully hereinafter with reference to the accompanying drawings, in which example embodiments of the inventions are shown. This invention may, however, be embodied in many different forms and should not be construed as limited to the embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on another element, it may be on the entire surface of the other element and may not be on a portion of an edge of the other element.

Reference will now be made in detail to embodiments of the invention, examples of which are illustrated in the accompanying drawings.

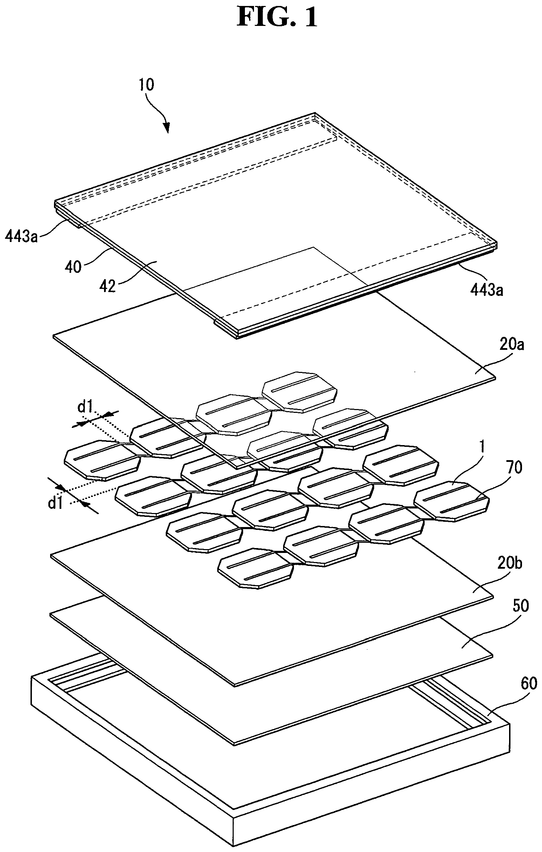

FIG. 1 is an exploded perspective view schematically showing a solar cell module according to an embodiment of the invention.

As shown in FIG. 1, a solar cell module 10 according to an embodiment of the invention includes a plurality of solar cells 1, protective layers 20a and 20b for protecting the solar cells 1, a transparent member 40 on the protective layer 20a (hereinafter, referred to as "upper protective layer") positioned on a light receiving surface of the solar cells 1, a back sheet 50 underlying the protective layer 20b (hereinafter, referred to as "lower protective layer") positioned on a surface, opposite the light receiving surface, on which light is not incident, and a frame 60 for receiving the above components 1, 20a, 20b, 40, and 50.

The back sheet 50 prevents moisture or oxygen from penetrating into a back surface of the solar cell module 10, thereby protecting the solar cells 1 from an external environment. The back sheet 50 may have a multi-layered structure including a moisture/oxygen penetrating prevention layer, a chemical corrosion prevention layer, an insulation layer, etc.

The upper and lower protective layers 20a and 20b prevent corrosion of metal resulting from the moisture penetration and protect the solar cell module 10 from an impact. The upper and lower protective layers 20a and 20b and the solar cells 1 form an integral body when a lamination process is performed in a state where the upper and lower protective layers 20a and 20b are respectively positioned on and under the solar cells 1. The upper and lower protective layers 20a and 20b may be formed of ethylene vinyl acetate (EVA), polyvinyl butyral (PVB), partial oxide of ethylene vinyl acetate (EVA), silicon resin, ester-based resin, and olefin-based resin. Other materials may be used. At least one of the upper and lower protective layers 20a and 20b may have an embossed and/or textured surface.

The transparent member 40 on the upper protective layer 20a is formed of a tempered glass with a high transmittance capable of preventing damage. The tempered glass may be a low iron tempered glass containing a small amount of iron. The transparent member 40 may have an embossed surface, such as at its inner surface, so as to increase a scattering effect of light. A surface of the transparent member 40 may be textured. The transparent member 40 may be formed of plastic or material other than glass or plastic. When formed of glass, the transparent member 40 may be a plate of glass or a plate of tempered glass.

The plurality of solar cells 1 is arranged in a matrix structure and is connected in series to one another using a plurality of connectors 70. Although FIG. 1 shows the solar cells 1 having the structure of 4x4 matrix, the number of solar cells 1 in column and/or row directions may vary, if necessary. In the embodiment of the invention, a distance d1 between the adjacent solar cells 1 may be 2 mm to 3 mm.

The frame 60 receives an integral body including the components 50, 20b, 1, 20a, and 40. The frame 60 may be formed of a material, for example, aluminum that is coated with an insulating material and does not corrode and is not deformed by an external environment. The frame 60 has a structure that is easy to install.

A method for manufacturing the solar cell module 10 may sequentially include testing the plurality of solar cells 1, electrically connecting the tested solar cells 1 to one another using the plurality of connectors 70, sequentially disposing the components 1, 20a, 20b, 40, and 50, for example, sequentially disposing the back sheet 50, the lower protective layer 20b, the solar cells 1, the upper protective layer 20a, and the transparent member 40 from the bottom of the solar cell module 10 in the order named, performing a lamination process in a vacuum state to form an integral body of the components 1, 20a, 20b, 40, and 50, performing an edge trimming process, testing the solar cell module 10, and the like.

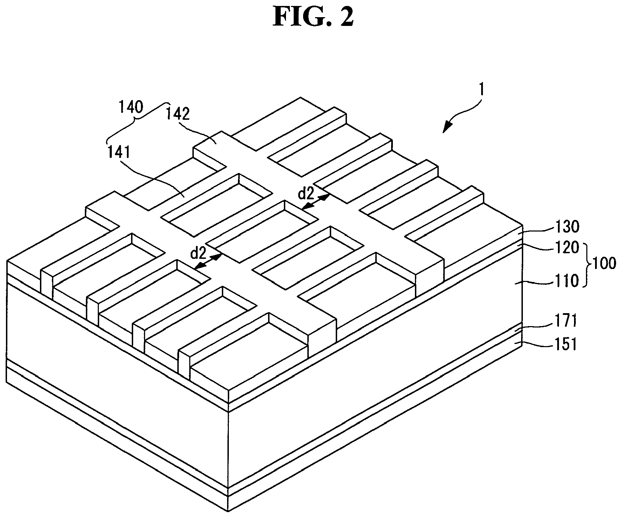

The solar cell 1 according to the embodiment of the invention is described below with reference to FIG. 2.

As shown in FIG. 2, the solar cell 1 includes a substrate 100 including a first impurity region 110 and an emitter layer 120 corresponding to a second impurity region, an anti-reflection layer 130 positioned on the emitter layer 120 of a surface (hereinafter, referred to as "a front surface") of the substrate 100 on which light is incident, a front electrode part 140 positioned on the emitter layer 120, a back electrode 151 positioned on a surface (hereinafter, referred to as "a back surface") of the substrate 100, opposite the front surface of the substrate 100, on which the light is not incident, and a back surface field (BSF) layer 171 underlying the back electrode 151.

The first impurity region 110 is positioned in the semiconductor substrate 100 formed of first conductive type silicon, for example, p-type silicon, though not required. The first impurity region 110 contains first conductive type impurities. The first impurity region 110 may contain impurities of a group III element such as boron (B), gallium (Ga), and indium (In). Silicon used in the substrate 100 is crystalline silicon such as polycrystalline silicon. Further, the substrate 100 may be formed of n-type silicon. In this case, the first impurity region 110 may contain impurities of a group V element such as phosphorus (P), arsenic (As), and antimony (Sb).

The substrate 100 may be textured to have a textured surface corresponding to an uneven surface. In this case, because an amount of light incident on the substrate 100 increases because of the textured surface of the substrate 100, the efficiency of the solar cell 1 is improved.

The emitter layer 120 is the second impurity region of a second conductive type (e.g., n-type) opposite the first conductive type of the substrate 100. Thus, the first impurity region 110 and the emitter layer 120 of the substrate 100 form a p-n junction. Most of a remaining region excluding the emitter layer 120 from the substrate 100 is the first impurity region 110.

A plurality of electron-hole pairs produced by light incident on the substrate 100 are separated into electrons and holes by a built-in potential difference resulting from the p-n junction of the first impurity region 110 and the emitter layer 120. Then, the separated electrons move to the n-type semiconductor, and the separated holes move to the p-type semiconductor. Thus, when the substrate 100 is of the p-type and the emitter layer 120 is of the n-type in the embodiment of the invention, the separated holes move to the first impurity region 110 and the separated electrons move to the emitter layer 120.

Because the first impurity region 110 and the emitter layer 120 form the p-n junction, the emitter layer 120 may be of the p-type if the substrate 100 is of the n-type unlike the embodiment of the invention described above. In this case, the separated electrons move to the first impurity region 110 and the separated holes move to the emitter layer 120.

The anti-reflection layer 130 on the emitter layer 120 reduces a reflectance of light incident on the substrate 100 and increases an amount of light absorbed by the substrate 100.

The front electrode part 140 includes a plurality of front electrodes 141 and a plurality of front electrode current collectors 142.

The front electrodes 141 are electrically and physically connected to the emitter layer 120 and extend substantially parallel to one another in a fixed direction. The front electrodes 141 collect carriers (e.g., electrons) moving to the emitter layer 120.

The front electrode current collectors 142 extend substantially parallel to one another in a direction crossing the front electrodes 141 on the emitter layer 120 and are electrically and physically connected to the emitter layer 120 and the front electrodes 141. The front electrode current collectors 142 are positioned on the same level layer as the front electrodes 141. The front electrode current collectors 142 are electrically and physically connected to the front electrodes 141 at each of crossings of the front electrodes 141 and the front electrode current collectors 142. Because the front electrode current collectors 142 are connected to the front electrodes 141, the front electrode current collectors 142 collect carriers transferred from the front electrodes 141 and output the carriers to an external device.

Although FIG. 2 shows the two front electrode current collectors 142, the number of front electrode current collectors 142 may vary. Further, a width of each front electrode current collector 142 varies depending on the number of front electrode current collectors 142 formed on the substrate 100. For example, when the two front electrode current collectors 142 are formed, a width d2 of each front electrode current collector 142 may be about 2 mm. When the three front electrode current collectors 142 are formed, the width d2 of each front electrode current collector 142 maybe about 1.5 mm.

The front electrode part 140 contains a conductive material such as silver (Ag) and may contain at least one selected from the group consisting of nickel (Ni), copper (Cu), aluminum (Al), tin (Sn), zinc (Zn), indium (In), titanium (Ti), gold (Au), and a combination thereof. Other materials may be used.

The anti-reflection layer 130 is positioned on the emitter layer 120, on which the front electrode part 140 is not positioned, because of the front electrode part 140 electrically and physically connected to the emitter layer 120.

The back electrode 151 is positioned on almost the entire back surface of the substrate 100. The back electrode 151 collects carriers (e.g., holes) moving to the first impurity region 110.

The back electrode 151 contains at least one conductive material such as aluminum (Al) and may contain at least one selected from the group consisting of nickel (Ni), copper (Cu), silver (Ag), tin (Sn), zinc (Zn), indium (In), titanium (Ti), gold (Au), and a combination thereof. Other materials may be used.

The BSF layer 171 between the back electrode 151 and the first impurity region 110 of the substrate 100 is a region (for example, a p⁺-type region) formed by more heavily doping the substrate 100 with impurities of the same conductive type as the first impurity region 110 than the substrate 100.

Hence, the movement of electrons to a back surface of the first impurity region 110 is prevented or reduced by a potential barrier resulting from a difference between impurity concentrations of the first impurity region 110 and the BSF layer 171. Thus, a recombination and/or a disappearance of electrons and holes around the first impurity region 110 are prevented or reduced.

The solace cell 1 having the above-described structure may further include a plurality of back electrode current collectors on the back surface of the substrate 100. The back electrode current collectors may have a structure similar to the front electrode current collectors 142. In other words, the back electrode current collectors may be electrically connected to the back electrode 151, collect carriers transferred from the back electrode 151, and output the carriers to an external device. The back electrode current collectors may contain at least one conductive material such as Ag.

An operation of the solar cell 1 according to the embodiment of the invention having the above-described structure is described below.

When light irradiated to the solar cell 1 is incident on the substrate 100 through the emitter layer 120, a plurality of electron-hole pairs is generated in the substrate 100 by light energy based on the incident light. Further, a reflection loss of the light incident on the substrate 100 decreases because of the anti-reflection layer 130, and thus an amount of the light incident on the substrate 100 increases. The electron-hole pairs are separated from each other by the p-n junction of the first impurity region 110 and the emitter layer 120, and the separated electrons move to the n-type emitter layer 120 and the separated holes move to the p-type first impurity region 110. The electrons moving to the n-type emitter layer 120 are collected by the front electrodes 141 and then are transferred to the front electrode current collectors 142. The holes moving to the first impurity region 110 are collected by the back electrode 151 through the BSF layer 171. When the front electrode current collectors 142 are connected to the back electrode 151 using electric wires, current flows therein to thereby enable use of the current for electric power.

As an amount of light incident on the substrate 100 increases, the efficiency of the solar cell 1 is generally improved.

However, because the front electrodes 141 and the front electrode current collectors 142 are positioned on the incident surface of the substrate 100 as shown in FIG. 2, an incident area of light decreases by the front electrodes 141 and the front electrode current collectors 142. Hence, an amount of light incident on the substrate 100 decreases.

An anti-reflection portion 41 capable of having various configurations is patterned on a portion of a surface (hereinafter, referred to as "an inner surface") of the transparent member 40, which is not exposed to the outside and is opposite to the upper protective layer 20a, so as to prevent or decrease a reduction in an incident amount of light. The anti-reflection portion 41 is patterned on only a portion of the inner surface of the transparent member 40, instead of the entire inner surface thereof.

Further, as shown in FIG. 1, an anti-reflection portion 42 is positioned on a surface (hereinafter, referred to as "an outer surface") of the transparent member 40, which is opposite to the inner surface of the transparent member 40 and is exposed to the outside. The anti-reflection portion 42 is positioned on the entire outer surface of the transparent member 40. Alternatively, the anti-reflection portion 42 may be positioned on a portion of the outer surface which is not inserted into the frame 60 and is exposed to the outside, i.e., a remaining outer surface except an edge portion of the outer surface inserted into the frame 60. The anti-reflection portion 42 may be omitted, if desired.

The anti-reflection portions 41 and 42 may be formed of an oxide-based material such as aluminum oxide, titanium oxide, and silicon oxide or a nitride-based material such as silicon nitride. Further, the anti-reflection portions 41 and 42 may be formed of a transparent material. Similar to the anti-reflection layer 130, the anti-reflection portions 41 and 42 reduce a reflectance of light coming from the outside and refract the light in a desired direction, thereby increasing an amount of light incident on the solar cell module 10. The anti-reflection portions 41 and 42 can selectively refract light of a desired wavelength band using a refractive index or a thickness, etc., of each of the anti-reflection portions 41 and 42.

The solar cell module 10 includes an electricity generating region contributing to electricity generation using light incident on the substrate 100 and a non-electricity generating region not contributing to electricity generation. The non-electricity generating region of the solar cell module 10 blocks light from being incident on the substrate 100, or the solar cells 1 do not exist in the non-electricity generating region. An example of such a non-electricity generating region includes gaps between the solar cells 1.

The electricity generating region indicates a portion of a front surface of each solar cell 1 on which the front electrodes 141 and the front electrode current collectors 142 are not positioned. In other words, the electricity generating region is a portion of the substrate 100 on which light is directly incident. The non-electricity generating region indicates a portion of the solar cell module 10, in which the solar cells 1 are not positioned, and a portion of the front surface of each solar cell 1 on which the front electrodes 141 and the front electrode current collectors 142 are positioned.

In the embodiment of the invention, the transparent member 40 includes a region corresponding to an electricity generating region, which is opposite to and overlaps the electricity generating region of each solar cell 1, and a region corresponding to a non-electricity generating region, which is opposite to and overlaps the non-electricity generating region of each solar cell 1.

In the embodiment of the invention, the anti-reflection portion 41 is positioned on the inner surface of the transparent member 40 and is positioned in at least a portion of the electricity generating region of the transparent member 40.

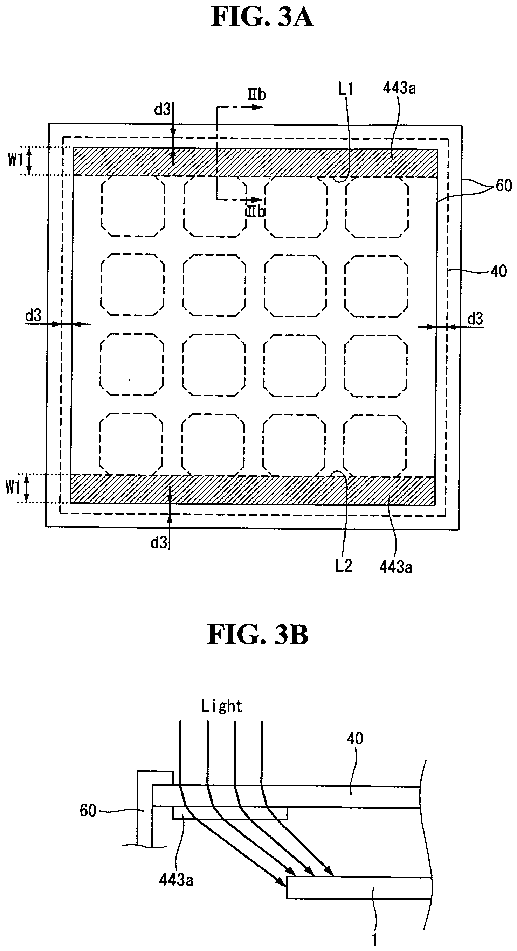

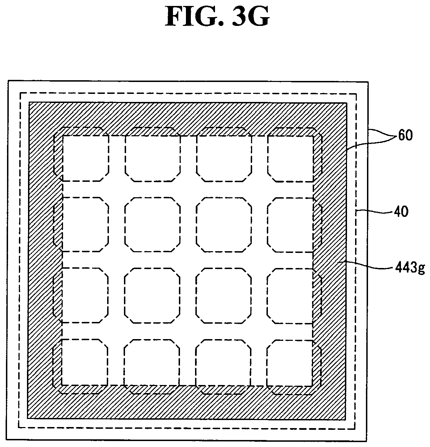

FIGS. 3A to 10 illustrate various configurations of the anti-reflection portion 41 positioned in the inner surface of the transparent member 40.

As shown in FIGS. 3A to 3G, the anti-reflection portion 41 is positioned in at least a portion of a portion (hereinafter, referred to as "an edge portion") corresponding to an edge area of the solar cell module 10 in the non-electricity generating region of the transparent member 40.

As shown in FIGS. 1, 3A, and 3B, the anti-reflection portion 41 has anti-reflection regions 443a in portions overlapping upper and lower edge areas of the solar cell module 10 in the edge portion of the transparent member 40. The anti-reflection region 443a is referred to as an edge portion 443a.

A longitudinal width W1 of each edge portion 443a is equal to a distance ranging from an imaginary line L1 connecting ends of the solar cells 1 arranged in a first row of the solar cell module 10 to the frame 60 adjacent to the imaginary line L1. Further, the longitudinal width W1 is equal to a distance ranging from an imaginary line L2 connecting ends of the solar cells 1 arranged in a last row of the solar cell module 10 to the frame 60 adjacent to the imaginary line L2.

As above, because the anti-reflection portion 41 is positioned in the non-electricity generating region of the inner surface of the transparent member 40, as shown in FIG. 3B, light incident on the non-electricity generating region of the transparent member 40 is refracted by the anti-reflection portion 41 and then is incident on the electricity generating region of the solar cell 1. Hence, an amount of light incident on each solar cell 1 increases, and electricity generating efficiency of each solar cell 1 is improved.

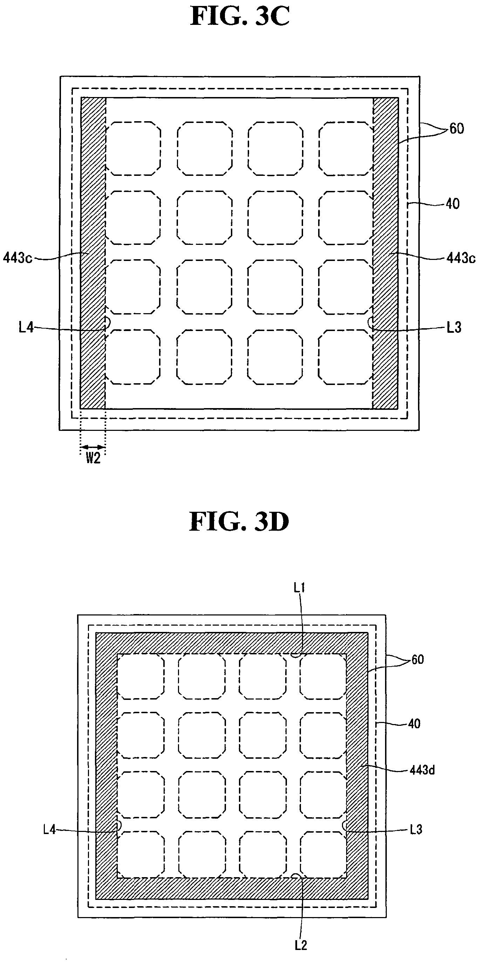

As shown in FIG. 3C, the anti-reflection portion 41 includes edge portions 443c (each corresponding to an anti-reflection portion) overlapping left and right edge areas of the solar cell module 10 in the edge portion of the transparent member 40. A transverse width W2 of each edge portion 443c is equal to a distance ranging from an imaginary line L3 connecting ends of the solar cells 1 arranged in a rightmost column of the solar cell module 10 to the frame 60 adjacent to the imaginary line L3. Further, the transverse width W2 is equal to a distance ranging from an imaginary line L4 connecting ends of the solar cells 1 arranged in a leftmost column of the solar cell module 10 to the frame 60 adjacent to the imaginary line L4.

Alternatively, as shown in FIG. 3D, the anti-reflection portion 41 includes an edge portion 443d corresponding to an anti-reflection portion positioned in the entire edge portion of the transparent member 40. The edge portion 443d substantially overlaps the entire edge portion of the solar cell module 10. Thus, the edge portion 443d has a rectangle ring shape. The edge portion 443d extends from the imaginary lines L1 to L4 connecting ends of the solar cells 1 straightly arranged in each of upper, lower, left and right edge portions of the solar cell module 10 to the frame 60 adjacent to the imaginary lines L1 to L4.

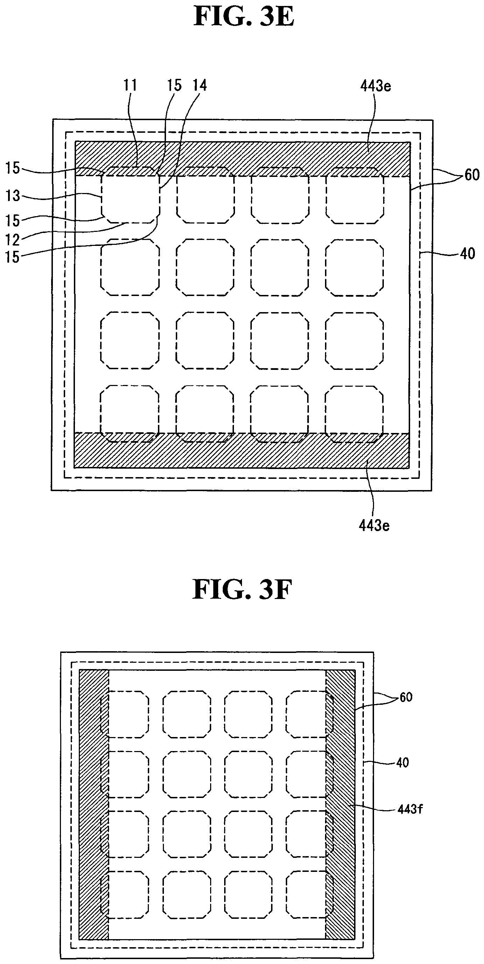

However, unlike FIGS. 3A, 3C, and 3D, as shown in FIGS. 3E to 3G, each of edge portions 443e, 443f, and 443g is positioned in the transparent member 40 beyond the imaginary lines L1 to L4 and partially overlaps the solar cells arranged in edge rows and/or edge columns of the solar cell module 10.

In the embodiment of the invention, each solar cell 1 has an upper side 11, a lower side 12, a first side 13 (e.g., a left side 13), a second side 14 (e.g., a right side 14), and four edges 15 connecting the upper and lower sides 11 and 12 to the sides 13 and 14. Each solar cell 1 has substantially an octagon shape.

Thus, as shown in FIGS. 3E and 3F, each of the edge portions 443e, 443f, and 443g extends from an end of the upper side 11, the lower side 12, the first side 13, or the second side 14 of a row of the adjacent solar cells and/or a column of the adjacent solar cells in the edge of the solar cell module 10 to an end of the edge 15 in a direction perpendicular to the side 11, 12, 13 or 14 and overlaps the row of the adjacent solar cells and/or the column of the adjacent solar cells. Hence, the anti-reflection portion 41 extends to a portion of the electricity generating region of the transparent member 40. In this case, because the anti-reflection portion 41 extends to the non-electricity generating region positioned around the edges 15, an amount of light incident on each solar cell 1 further increases.

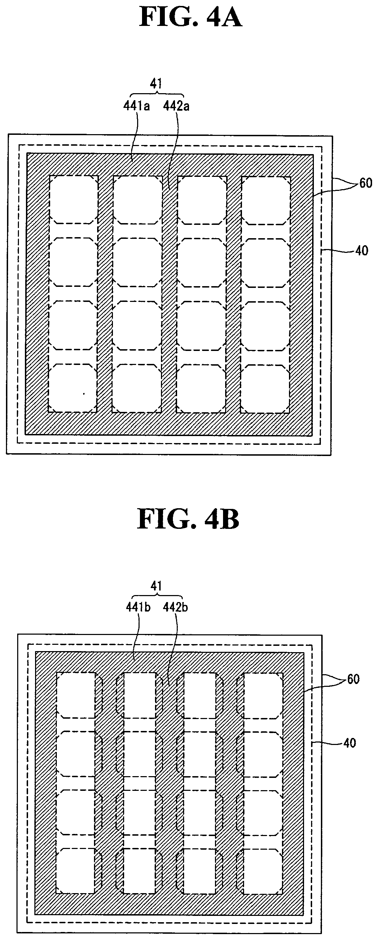

As shown in FIGS. 4A to 4D, the anti-reflection portion 41 includes edge portions 441a, 441b, 441c, and 441d and a plurality of longitudinal portions 442a, 442b, 442c, and 442d respectively connected to the edge portions 441a, 441b, 441c, and 441d. The edge portions 441a, 441b, 441c, and 441d are positioned in the edge portion of the transparent member 40 corresponding to the edge portion of the solar cell module 10, as described above. The longitudinal portions 442a, 442b, 442c, and 442d longitudinally extend between adjacent columns of the solar cells in the inner surface of the transparent member 40.

As shown in FIG. 4A, the longitudinal portions 442a overlap the non-electricity generating region between both ends of the adjacent columns of the solar cells. Thus, the longitudinal portions 442a are mainly positioned in the non-electricity generating region of the transparent member 40.

As shown in FIG. 4B, the longitudinal portions 442b overlap areas between the adjacent columns of the solar cells and edge areas of the adjacent columns of the solar cells. In other words, the longitudinal portions 442b partially overlap the adjacent columns of the solar cells. Thus, the longitudinal portions 442b are positioned in a portion of the electricity generating region as well as the non-electricity generating region of the transparent member 40.

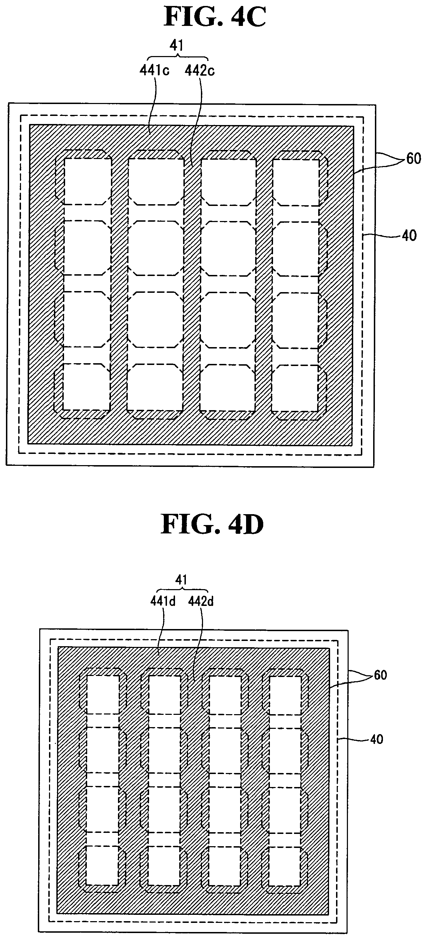

As shown in FIGS. 4C and 4D, each of the edge portions 441c and 441d of the anti-reflection portion 41 extend to portions overlapping edge areas of the adjacent rows or the adjacent columns of the solar cells, as described above with reference to FIGS. 3E and 3F.

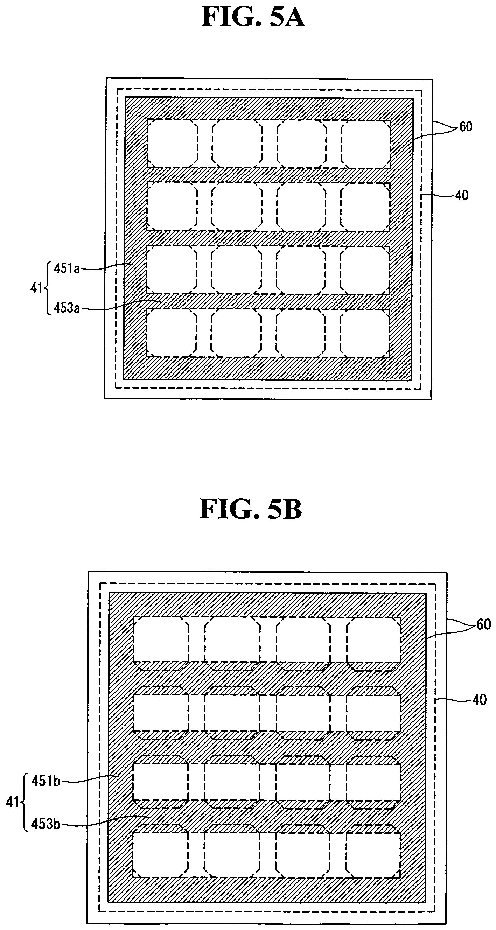

As shown in FIGS. 5A to 5D, the anti-reflection portion 41 includes edge portions 451a, 451b, 451c, and 451d and a plurality of transverse portions 453a, 453b, 453c, and 453d respectively connected to the edge portions 451a, 451b, 451c, and 451d. The edge portions 451a, 451b, 451c, and 451d are positioned in the edge portion of the transparent member 40 corresponding to the edge portion of the solar cell module 10, as described above. The transverse portions 453a, 453b, 453c, and 453d extend between adjacent rows of the solar cells in the inner surface of the transparent member 40 in a transverse direction.

As shown in FIG. 5A, the transverse portions 453a overlap the non-electricity generating region between both ends of the adjacent rows of the solar cells. Thus, the transverse portions 453a are mainly positioned in the non-electricity generating region of the transparent member 40.

As shown in FIG. 5B, the transverse portions 453b overlap not only portions between the adjacent rows of the solar cells but also edge areas of the adjacent rows of the solar cells. In other words, the transverse portions 453b partially overlap the adjacent rows of the solar cells. Thus, the transverse portions 453b are positioned in a portion of the electricity generating region as well as the non-electricity generating region of the transparent member 40.

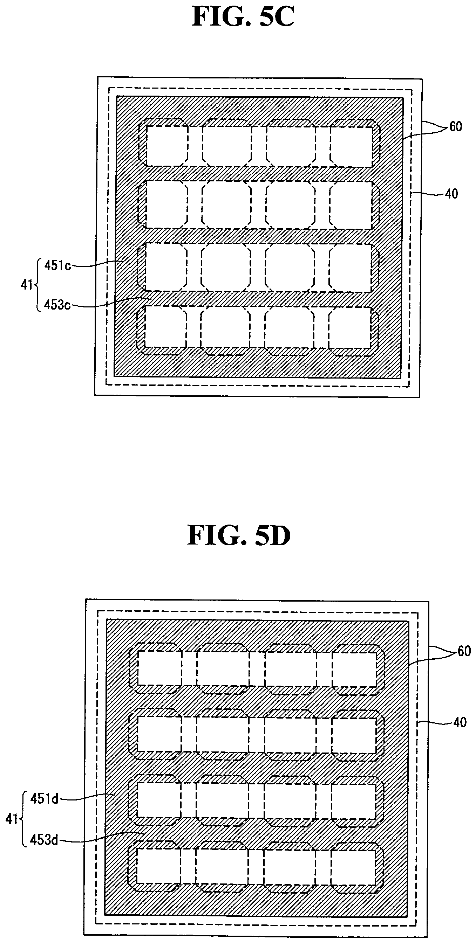

As shown in FIGS. 5C and 5D, the edge portions 451c and 451d extend to a portion overlapping edge areas of the adjacent rows or the adjacent columns of the solar cells, in the same manner as FIGS. 4C and 4D. In other words, each of the edge portions 451c and 451d overlaps a corresponding edge portion.

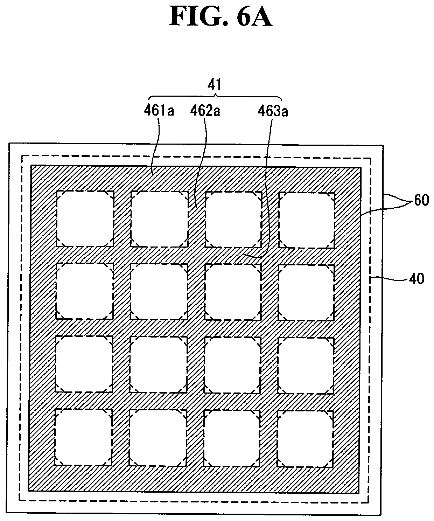

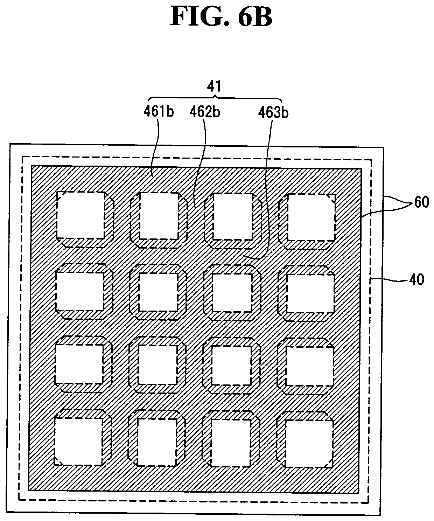

As shown in FIGS. 6A and 6B, the anti-reflection portion 41 includes edge portions 461a and 461b, a plurality of longitudinal portions 462a and 462b respectively connected to the edge portions 461a and 461b, and a plurality of transverse portions 463a and 463b respectively connected to the edge portions 461a and 461b. Hence, the anti-reflection portion 41 has a lattice shape.

Since the edge portions 461a and 461b, the longitudinal portions 462a and 462b, and the transverse portions 463a and 463b shown in FIGS. 6A and 6B are substantially the same as the edge portions 441a to 441d and 451a to 451d, the longitudinal portions 442a to 442d, and the transverse portions 453a to 453d shown in FIGS. 4A to 5D, a further description may be briefly made or may be entirely omitted.

Unlike FIGS. 6A and 6B, at least a portion of each of the edge portions 461a and 461b may extend to edge areas of the adjacent rows or the adjacent columns of the solar cells and overlap the edge areas. The longitudinal portions 462a and 462b or the transverse portions 463a and 463b may extend to edge areas of the adjacent rows or the adjacent columns of the solar cells.

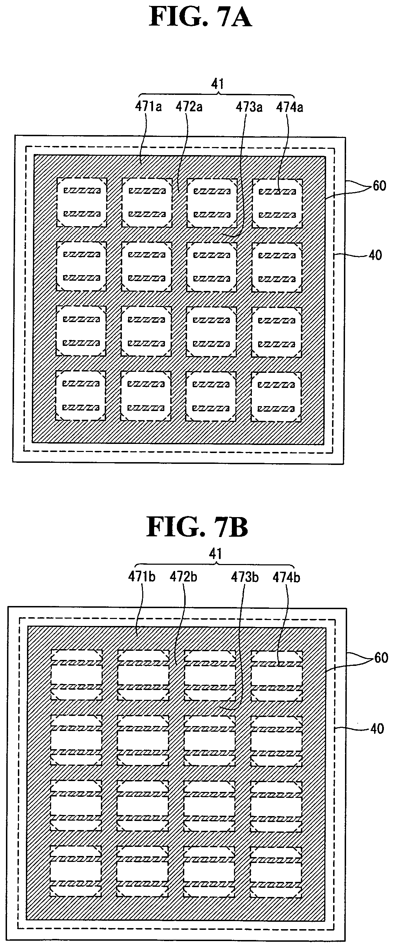

Further, the anti-reflection portion 41 positioned in the inner surface of the transparent member 40 is positioned at a location corresponding to the non-electricity generating region positioned inside each solar cell 1. This is described with reference to FIGS. 7A and 7B.

As shown in FIGS. 7A and 7B, the anti-reflection portion 41 positioned in the inner surface of the transparent member 40 further includes a plurality of auxiliary patterns 474a and 474b, which are positioned to overlap a formation location of the front electrode current collectors 142 of each solar cell 1, in addition to edge portions 471a and 471b, longitudinal portions 472a and 472b, and transverse portions 473a and 473b.

Since the edge portions 471a and 471b, the longitudinal portions 472a and 472b, and the transverse portions 473a and 473b shown in FIGS. 7A and 7B are substantially the same as the edge portions 461a and 461b, the longitudinal portions 462a and 462b, and the transverse portions 463a and 463b shown in FIGS. 6A and 6B, a further description may be briefly made or may be entirely omitted.

As shown in FIG. 7A, the auxiliary patterns 474a overlap substantially correspondingly to a formation portion of the front electrode current collectors 142 of each solar cell 1. Thus, the auxiliary patterns 474a are separated from the edge portions 471a.

On the other hand, as shown in FIG. 7B, the auxiliary patterns 474b are connected to the edge portions 471b along the formation portion of the front electrode current collectors 142 of each solar cell 1. Hence, the auxiliary patterns 474b and the edge portions 471b form an integral body.

It is preferable, though not required, that a width of each of the auxiliary patterns 474a and 474b is equal to or greater than a width of the front electrode current collector 142 of each solar cell 1.

As described above, at least a portion of each of the edge portions 471a and 471b may extend to a portion corresponding to edge areas of the adjacent rows or adjacent columns of the solar cells. The longitudinal portions 472a and 472b, the transverse portions 473a and 473b, or both may extend to a portion corresponding to edge areas of the adjacent rows or adjacent columns of the solar cells.

A portion d3 of the transparent member 40 shown in FIGS. 3A to 10 is surrounded by the frame 60. Thus, as described above, the anti-reflection portion 41 is not positioned in the portion d3 of the transparent member 40 surrounded by the frame 60.

On the contrary, the anti-reflection portion 41 shown in FIGS. 3A to 7B may extend to an end of the inner surface of the transparent member 40, i.e., may be positioned on the entire inner surface of the transparent member 40.

Further, when the solar cell module 10 does not include the frame 60, a portion for a fixation between the transparent member 40 and the frame 60 is not necessary. Accordingly, because the anti-reflection portion 41 may be positioned on the entire inner surface of the transparent member 40, the anti-reflection portion 41 may allow light incident on the non-electricity generating region of the transparent member 40 to be again incident on the electricity generating region.

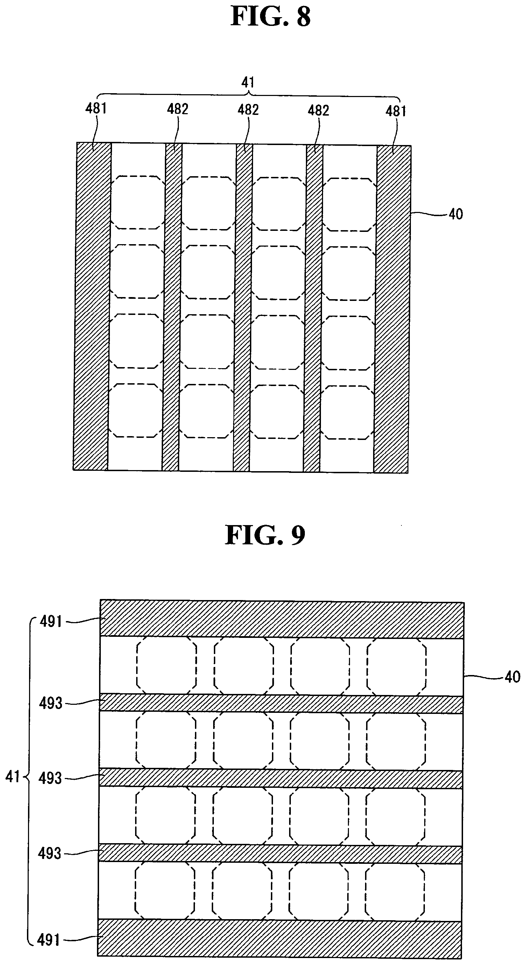

As shown in FIG. 8, unlike FIGS. 4A to 4D, the anti-reflection portion 41 includes a portion of an edge of the transparent member 40 (i.e., left and right edge portions 481 of the transparent member 40) and a plurality of longitudinal portions 482.

As shown in FIG. 9, unlike FIGS. 5A to 5D, the anti-reflection portion 41 includes a portion of an edge of the transparent member 40 (i.e., upper and lower edge portions 491 of the transparent member 40) and a plurality of transverse portions 493.

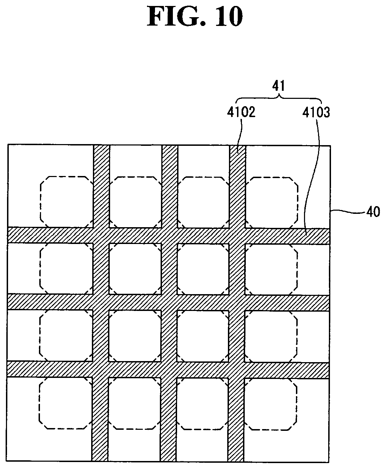

As shown in FIG. 10, unlike FIGS. 6A and 6B, the anti-reflection portion 41 includes a plurality of longitudinal portions 4102 and a plurality of transverse portions 4103 and does not include an edge portion.

In FIGS. 8 to 10, the longitudinal portions 482 and 4102 and/or the transverse portions 493 and 4103 longitudinally extend to the end of the inner surface of the transparent member 40. However, as shown in FIGS. 3A to 7B, the longitudinal portions 482 and 4102 and/or the transverse portions 493 and 4103 may longitudinally and/or transversely extend to a portion prior to reaching an overlapping portion between the transparent member 40 and the frame 60. Further, the edge portions 481 and 491 may longitudinally extend to a portion prior to reaching an overlapping portion between the transparent member 40 and the frame 60.

Further, in FIGS. 8 to 10, the longitudinal portions 482 and 4102 and/or the transverse portions 493 and 4103 are positioned between two adjacent rows and/or two adjacent columns of the solar cells. However, as described above, the longitudinal portions 482 and 4102 and/or the transverse portions 493 and 4103 may extend to the edge areas of the adjacent rows and/or the edge portions of the adjacent columns of the solar cells. Further, the edge portions 481 and 491 may extend to the edge areas of the adjacent rows and/or the edge portions of the adjacent columns of the solar cells.

Further, unlike FIGS. 6A and 6B, the anti-reflection portion 41 may include only the auxiliary patterns 474a and 474b or may include at least one of the auxiliary patterns 474a and 474b, the edge portions 471a and 471b, the longitudinal portions 472a, 472b, 482, and 4102, and the transverse portions 473a, 473b, 493, and 4103.

As described above, when light incident on the non-electricity generating region is again incident on the electricity generating region by positioning the anti-reflection portion 41 on the inner surface of the transparent member 40 correspondingly to the non-electricity generating region of the solar cell module 10, the electricity generating efficiency of the solar cell module 10 increased by about 4 % to 5%.

In the embodiment of the invention, because the anti-reflection portion 41 is formed at a location corresponding to at least a portion of the non-electricity generating region instead of the entire inner surface of the transparent member 40, the manufacturing cost of the solar cell module is reduced. In other words, because a related art anti-reflection portion is formed in a portion corresponding to the non-electricity generating region as well as the non-electricity generating region, an amount of material for forming the anti-reflection portion increased. However, in the embodiment of the invention, because the anti-reflection portion 41 is formed at a location corresponding to at least a portion of the non-electricity generating region, an amount of material for forming the anti-reflection portion decreases.

Further, the surface of the anti-reflection portion 41 is generally not a flat surface but an uneven surface. Accordingly, as a formation area of the anti-reflection portion 41 increases, uniformity of the anti-reflection portion 41 is degraded. Hence, anti-reflection efficiency of the anti-reflection portion 41 is reduced. However, in the embodiment of the invention, because the anti-reflection portion 41 is formed in a portion of the inner surface of the transparent member 40 instead of the entire inner surface of the transparent member 40, the surface uniformity of the anti-reflection portion 41 increases. Hence, anti-reflection efficiency of the anti-reflection portion 41 is improved.

Furthermore, because foams are generated in a portion of the protective layers 20a and 20b contacting the anti-reflection portion 41 in the lamination process for forming an integral body of the anti-reflection portion 41 and the protective layers 20a and 20b, light incidence is adversely affected by the foams. However, in the embodiment of the invention, because the formation area of the anti-reflection portion 41 decreases, the frequency of foam generation decreases.
In the embodiment of the invention, the anti-reflection portion 41 existing in a portion of the inner surface of the transparent member 40 may be formed by coating the portion of the inner surface with a desired material using a roller. A travelling direction of the roller, the used number of the roller, or etc. are determined depending on the pattern shape, the thickness, etc. of the anti-reflection portion 41. Further, the anti-reflection portion including a plurality of patterns each having a different width may be rapidly formed by simultaneously using various rollers each having a different width.

## Claims

1. A solar cell module, comprising;
a plurality of solar cells (1);
a protective layer (20a) positioned on the plurality of solar cells; and
a transparent member (40) positioned on the protective layer, the transparent member including a first anti-reflection portion (41) patterned on an inner surface of the transparent member, the inner surface being a surface facing the plurality of solar cells,
wherein the inner surface of the transparent member includes a first region corresponding to and facing an electricity generating region of the solar cell module, and a second region corresponding to and facing a non-electricity generating region of the solar cell module,
the first anti-reflection portion (41) is positioned in the second region of the transparent member, and
the first anti-reflection portion (41) is configured to refract light incident on the non-electricity generating region of the transparent member (40) to the electricity generating region of the solar cell module.

2. The solar cell module of claim 1, wherein the transparent member (40) has an embossed surface.

3. The solar cell module of claim 1, wherein the first anti-reflection portion (41) includes at least one of an oxide-based material and a nitride based material.

4. The solar cell module of claim 3, wherein the oxide-based material includes at least one of aluminum oxide, titanium oxide, and silicon oxide, and the nitride-based material includes silicon nitride.

5. The solar cell module of claim 1, wherein the first anti-reflection portion (41) includes an edge portion (441a, 441b, 441c, 441d) overlapping at least a portion of an edge area of the solar cell module.

6. The solar cell module of claim 5, wherein the edge portion (441a, 441b, 441c, 441d) of the first anti-reflection portion (41) further overlaps an edge area of at least one of a row and a column of the solar cells (1) positioned at a location corresponding to the edge area of the solar cell module.

7. The solar cell module of claim 1, wherein the first anti-reflection portion (41) includes a plurality of longitudinal portions (442a, 442b, 442c, 442d) overlapping an area between adjacent columns of the solar cells, a plurality of transverse portions (453a, 453b, 453c, 453d) overlapping an area between adjacent rows of the solar cells, or both.

8. The solar cell module of claim 7, wherein the plurality of longitudinal portions further overlaps edge areas of the adjacent columns of the solar cells, the plurality of transverse portions further overlaps edge areas of the adjacent rows of the solar cells, or both.

9. The solar cell module of claim 1, wherein the first anti-reflection portion (41) has a lattice shape.

10. The solar cell module of claim 1, wherein each of the plurality of solar cells (1) includes a plurality of current collectors (142), and
the first anti-reflection portion (41) includes a plurality of auxiliary patterns (474a, 474b) overlapping the plurality of current collectors.

11. The solar cell module of claim 1, wherein the first anti-reflection portion (41) extends to an end of the transparent member (40).

12. The solar cell module of claim 1, wherein the first anti-reflection portion (41) extends to a portion where the frame and the inner surface of the transparent member (40) meet each other.

13. The solar cell module of claim 1, wherein the transparent member (40) further includes a second anti-reflection portion (42) on an outer surface opposite the inner surface of the transparent member.

14. The solar cell module of claim 13, wherein the second anti-reflection portion (42) is positioned on the entire outer surface of the transparent member (40).

## Patentansprüche

1. Solarzellenmodul umfassend:
eine Mehrzahl von Solarzellen (1);
eine Schutzschicht (20a), die auf der Mehrzahl von Solarzellen angeordnet ist; und
ein transparentes Element (40), das auf der Schutzschicht angeordnet ist, wobei das transparente Element einen ersten Antireflexionsabschnitt (41) umfasst, der auf einer Innenfläche des transparenten Elements gemustert ist, wobei die Innenfläche eine der Mehrzahl von Solarzellen zugewandte Oberfläche ist,
wobei die Innenfläche des transparenten Elements einen ersten Bereich, der einem Elektrizitätserzeugungsbereich des Solarzellenmoduls entspricht und diesem zugewandt ist, und einen zweiten Bereich umfasst, der einem Nichtelektrizitätserzeugungsbereich des Solarzellenmoduls entspricht und diesem zugewandt ist,
der erste Antireflexionsabschnitt (41) in dem zweiten Bereich des transparenten Elements angeordnet ist und
der erste Antireflexionsabschnitt (41) so eingerichtet ist, dass Licht, das auf den Nichtelektrizitätserzeugungsbereich des transparenten Elements (40) einfällt, zu dem Elektrizitätserzeugungsbereich des Solarzellenmoduls gebrochen wird.

2. Solarzellenmodul nach Anspruch 1, wobei das transparente Element (40) eine geprägte Oberfläche aufweist.

3. Solarzellenmodul nach Anspruch 1, wobei der erste Antireflexionsabschnitt (41) mindestens eines von einem Material auf Oxidbasis und einem Material auf Nitridbasis umfasst.

4. Solarzellenmodul nach Anspruch 3, wobei das Material auf Oxidbasis mindestens eines von Aluminiumoxid, Titanoxid und Siliciumoxid enthält und das Material auf Nitridbasis Siliciumnitrid enthält.

5. Solarzellenmodul nach Anspruch 1, wobei der erste Antireflexionsabschnitt (41) einen Randabschnitt (441a, 441b, 441c, 441d) umfasst, der mindestens einen Abschnitt eines Randbereichs des Solarzellenmoduls überlappt.

6. Solarzellenmodul nach Anspruch 5, wobei der Randabschnitt (441a, 441b, 441c, 441d) des ersten Antireflexionsabschnitts (41) ferner einen Randbereich mindestens einer von einer Reihe und einer Spalte der Solarzellen (1) überlappt, die an einem Ort, der dem Randbereich des Solarzellenmoduls entspricht, angeordnet sind.

7. Solarzellenmodul nach Anspruch 1, wobei der erste Antireflexionsabschnitt (41) eine Mehrzahl von Längsabschnitten (442a, 442b, 442c, 442d), die einen Bereich zwischen benachbarten Spalten der Solarzellen überlappen, und eine Mehrzahl von Querabschnitten (453a, 453b, 453c, 453d), die einen Bereich zwischen benachbarten Reihen der Solarzellen überlappen, oder beide umfasst.

8. Solarzellenmodul nach Anspruch 7, wobei die Mehrzahl von Längsabschnitten ferner Randbereiche der benachbarten Spalten der Solarzellen überlappt, die Mehrzahl von Querabschnitten ferner Randbereiche der benachbarten Reihen der Solarzellen überlappt oder beides.

9. Solarzellenmodul nach Anspruch 1, wobei der erste Antireflexionsabschnitt (41) eine Gitterform aufweist.

10. Solarzellenmodul nach Anspruch 1, wobei jede aus der Mehrzahl von Solarzellen (1) eine Mehrzahl von Stromkollektoren (142) umfasst und
der erste Antireflexionsabschnitt (41) eine Mehrzahl von Hilfsmustern (474a, 474b) umfasst, welche die Mehrzahl von mehreren Stromkollektoren überlappen.

11. Solarzellenmodul nach Anspruch 1, wobei sich der erste Antireflexionsabschnitt (41) zu einem Ende des transparenten Elements (40) erstreckt.

12. Solarzellenmodul nach Anspruch 1, wobei sich der erste Antireflexionsabschnitt (41) zu einem Abschnitt erstreckt, wo der Rahmen und die Innenfläche des transparenten Elements (40) aufeinandertreffen.

13. Solarzellenmodul nach Anspruch 1, wobei das transparente Element (40) ferner einen zweiten Antireflexionsabschnitt (42) an einer Außenfläche gegenüber der Innenfläche des transparenten Elements umfasst.

14. Solarzellenmodul nach Anspruch 13, wobei der zweite Antireflexionsabschnitt (42) auf der gesamten Außenfläche des transparenten Elements (40) angeordnet ist.

## Revendications

1. Module de cellules solaires, comprenant :
une pluralité de cellules solaires (1) ;
une couche de protection (20a) positionnée sur la pluralité de cellules solaires ; et
un élément transparent (40) positionnée sur la couche de protection, l'élément transparent comprenant une première partie antireflet (41) à motifs sur une surface intérieure de l'élément transparent, la surface intérieure étant une surface faisant face à la pluralité de cellules solaires,
la surface intérieure de l'élément transparent comprenant une première région correspondant à une région de production électrique du module de cellules solaires et y faisant face et une seconde région correspondant à une région de production non électrique du module de cellules solaires et y faisant face,
la première partie antireflet (41) étant conçue pour réfracter la lumière incidente sur la région de production non électrique de l'élément transparent (40) vers la région de production électrique du module de cellules solaires.

2. Module de cellules solaires selon la revendication 1, l'élément transparent (40) ayant une surface estampée.

3. Module de cellules solaires selon la revendication 1, la première partie antireflet (41) comprenant au moins un matériau à base d'oxyde et un matériau à base de nitrure.

4. Module de cellules solaires selon la revendication 3, le matériau à base d'oxyde comprenant au moins un oxyde d'aluminium et/ou un oxyde de titane et un oxyde de silicium et le matériau à base de nitrure comprenant le nitrure de silicium.

5. Module de cellules solaires selon la revendication 1, la première partie antireflet (41) comprenant une partie marginale (441a, 441b, 441c, 441d) chevauchant au moins une partie d'une zone marginale du module de cellules solaires.

6. Module de cellules solaires selon la revendication 5, la partie marginale (441a, 441b, 441c, 441d) de la première partie antireflet (41) chevauchant en outre une zone marginale d'au moins une rangée et/ou une colonne des cellules solaires (1) positionnées à un emplacement correspondant à la zone marginale du module de cellules solaires.

7. Module de cellules solaires selon la revendication 1, la première partie antireflet (41) comprenant une pluralité de parties longitudinales (442a, 442b, 442c, 442d) chevauchant une zone entre des colonnes adjacentes des cellules solaires, une pluralité de parties transversales (453a, 453b, 453c, 453d) chevauchant une zone entre des rangées adjacentes des cellules solaires, ou les deux.

8. Module de cellules de solaires selon la revendication 7, la pluralité des parties longitudinales chevauchant en outre des zones marginales des colonnes adjacentes des cellules solaires, la pluralité des parties transversales chevauchant en outre des zones marginales des rangées adjacentes des cellules solaires, ou les deux.

9. Module de cellules solaires selon la revendication 1, la première partie antireflet (41) ayant une forme de treillis.

10. Module de cellules solaires selon la revendication 1, chaque cellule solaire de la pluralité de cellules solaires (1) comprenant une pluralité de collecteurs de courant (142), et
la première partie antireflet (41) comprenant une pluralité de motifs auxiliaires (474a, 474b) chevauchant la pluralité de collecteurs de courant.

11. Module de cellules solaires selon la revendication 1, la première partie antireflet (41) s'étendant vers une extrémité de l'élément transparent (40).

12. Module de cellules solaires selon la revendication 1, la première partie antireflet (41) s'étendant vers une partie où se rencontrent le cadre et la surface intérieure de l'élément transparent (40).

13. Module de cellules solaires selon la revendication 1, l'élément transparent (40) comprenant en outre une seconde partie antireflet (42) sur une surface extérieure en regard à la surface intérieure de l'élément transparent.

14. Module de cellules solaires selon la revendication 13, la seconde partie antireflet (42) étant positionnée sur toute la surface extérieure de l'élément transparent (40).
